# FASCICULE DE BREVET EUROPEEN

(11) **EP 0 411 079 B1**
(45) Date de publication et mention de la délivrance du brevet: **21.05.1997**
(21) Numéro de dépôt: 90902137.0
(22) Date de dépôt: 12.02.1990
(51) Int. Cl.: C23C 14/02

(54) **PROCEDE DE DEPOT D'AU MOINS UNE EPAISSEUR D'AU MOINS UN MATERIAU DECORATIF SUR UN OBJET ET OBJET DECORATIF REALISE SELON CE PROCEDE**
VERFAHREN ZUR ABSCHEIDUNG VON MINDESTENS EINER STÄRKE VON MINDESTENS EINEM DEKORATIVEN WERKSTOFF ÜBER EINEN GEGENSTAND UND DADURCH ERHALTENER GEGENSTAND
METHOD FOR THE DEPOSITION OF AT LEAST ONE THICKNESS OF AT LEAST ONE DECORATIVE MATERIAL TO AN OBJECT, AND DECORATIVE OBJECT OBTAINED BY SUCH METHOD

(30) Priorité: 17.02.1989 CH 574/89
(43) Date de publication de la demande: 06.02.1991
(73) Titulaire: PRECI-COAT S.A., 2300 La Chaux-de-Fonds (CH)
(72) Inventeur: MIREMAD, Bahman, CH-2000 Neuchâtel (CH); AUBERT, François, CH-2400 Le Locle (CH); GLAVAN, Branko, CH-2300 La Chaux-de-Fonds (CH)
(74) Mandataire: Nithardt, Roland
(86) Numéro de dépôt international: CH9000031
(87) Numéro de publication internationale: WO9009463

(56) Documents cités:
- GB-A- 2 000 812
- GB-A- 2 117 009
- GB-A- 2 130 795
- GB-A- 2 162 864
- GB-A- 2 166 162
- GB-A- 2 186 000
- US-A- 3 844 924
- CHEMICAL ABSTRACTS, Vol. 101, No. 2, Juillet 1984, (Columbus, Ohio, US), voir page 222, résume 10982q, & JP, A, 5935673
- PATENT ABSTRACTS OF JAPAN, Vol. 10, No. 318 (C-381) (2374), 29 Octobre 1986, & JP, A, 61127858

## Description

La présente invention concerne un procédé de dépôt d'au moins une épaisseur d'au moins un matériau décoratif résistant à l'usure et à la corrosion, sur un substrat constituant au moins une partie d'un objet décoratif, procédé dans lequel on prépare l'objet à traiter en lui faisant subir un décapage ionique, on dépose sur ledit substrat au moins une couche de fond en céramique comportant au moins l'un des éléments suivants : le titane, le zirconium, le hafnium, le vanadium, le niobium, le tantale, le chrome, le molybdène, le tungstène et l'aluminium, ou un alliage de ces éléments, cette couche de fond étant déposée au moyen d'un premier dispositif de dépôt en présence d'un gaz réactif, on active la surface de cette couche de fond par un bombardement ionique sous vide, et on dépose au moins un revêtement superficiel final de métal fin comportant au moins un des éléments suivants : l'or, le platine, le palladium, le rhodium, l'argent, l'irridium, l'osmium, le ruthénium ou le rhénium, ce revêtement superficiel étant déposé par dépôt sous vide au moyen d'un deuxième dispositif de dépôt, le dépôt sous vide étant effectué par l'un des procédés suivants : pulvérisation cathodique, évaporation sous vide ou dépôt ionique, le dépôt de la couche de fond et le revêtement superficiel étant effectués dans une même enceinte à vide au moyen de dispositifs de dépôt sous vide montés dans cette enceinte.

On demande très souvent que les surfaces des objets décoratifs aient une couleur dorée. Lorsque ces objets ne sont pas en or massif, mais fabriqués en métal non noble tel que le laiton, l'acier inoxydable, le zinc, etc., on peut obtenir cet aspect doré par application d'un revêtement superficiel d'or ou d'alliage d'or, le plus souvent par un procédé galvanique. Si l'on désire que ce revêtement soit résistant à l'usure et à la corrosion, son épaisseur doit atteindre au moins 10 µm.

A cet effet, on dépose en général galvaniquement une couche de base constituée d'un alliage de métal précieux à 14 ou 18 carats, sur laquelle on dépose une fine couche superficielle d'alliage d'or, ayant une pureté supérieure ou égale à 22 carats. et dont la couleur correspond exactement à la nuance désirée, soit par exemple les couleurs des alliages d'or standardisés définis par les Normes de l'Industrie Horlogère Suisse NIHS 03-50 (alliages 1N14, 2N18, 3N, 4N, 5N).

Pour des raisons économiques, et dans le but d'obtenir des revêtements résistants à l'usure et à la corrosion, on remplace depuis un certain nombre d'années les revêtements d'or par des couches de céramique de couleur dorée, comme par exemple les nitrures ou les carbonitrures de titane, zirconium, hafnium, etc.

Ces revêtements de céramique sont appliqués par des techniques de dépôt sous vide, telles que le dépôt chimique en phase vapeur, l'évaporation sous vide, le dépôt ionique ou la pulvérisation cathodique.

Cependant, la couleur de ces revêtements, et plus particulièrement leur brillance, ne correspond pas exactement aux nuances des alliages d'or normalisés. En général, on améliore l'aspect de ces revêtements en appliquant des techniques de dépôt galvanique ou de dépôt sous vide visant à déposer simultanément avec la céramique, ou par-dessus la céramique, de l'or ou un alliage d'or ayant la couleur et la brillance désirées. Ces techniques ont été décrites dans les brevets ou demandes de brevet CH 665 436, CH 631 040, DE 3 428 951, JP 58 153 776, EU 38 294 et CH 667 361.

Dans le cas le plus courant d'une amélioration de la couleur des revêtements de céramique par dépôt d'une couche finale d'un alliage d'or, les techniques appliquées présentent des difficultés qui limitent leur utilisation sur le plan économique :
- la technique de dépôt final d'un alliage d'or sous vide, par évaporation, dépôt ionique ou pulvérisation cathodique, telle qu'elle est décrite dans les brevets CH 631 040 ou DE 3 428 951, manque singulièrement de polyvalence, puisque pour chaque couleur ou composition d'alliage d'or désirée, il est nécessaire de changer la source de dépôt (source d'évaporation, cathode, etc.) ce qui représente des quantités non négligeables d'alliage d'or et des manipulations immobilisant l'installation de dépôt;
- la technique décrite dans les brevets CH 631 040 et JP 58 153 776 est une variante de la précédente, dans laquelle la présence d'une couche intermédiaire entre le revêtement céramique et la couche finale d'alliage d'or, obtenue par codéposition ou diffusion thermique, a pour but d'améliorer l'adhérence entre la couche d'alliage d'or et le revêtement céramique;
- la technique de dépôt final d'un alliage d'or par voie galvanique, telle que décrite dans le brevet CH 667 361, est compliquée. En effet, elle nécessite pour l'utilisateur de la technique des équipements de dépôt sous vide et des équipements de dépôt galvanique, des opérations supplémentaires et un coût en main-d'oeuvre plus élevé. En effet, bien souvent, les supports de substrats (bouclards) utilisés pour le dépôt sous vide ne conviennent pas au dépôt galvanique, ce qui implique de déplacer les substrats d'un type de support à l'autre.

Dans le cas d'une déposition simultanée de céramique et d'or, ou d'alliage d'or, telle qu'elle est décrite dans le brevet EU 38 294, ou du dépôt successif de fines lamelles de céramique et d'or, ou d'alliage d'or, tel qu'il est décrit dans le brevet CH 665 436, on perd en grande partie les avantages d'un revêtement composé d'une couche de fond dure en céramique et d'un revêtement superficiel en or ou alliage d'or. En effet, l'introduction d'or ou d'un alliage d'or dans la couche de céramique réduit sensiblement sa dureté et sa résistance mécanique et chimique. De plus, l'application dans toute l'épaisseur du revêtement de couches successives différentes allonge sensiblement la durée du procédé de déposition et diminue son intérêt sur le plan économique.

La présente invention se propose de pallier ces difficultés en offrant une possibilité d'appliquer par une technique de revêtement sous vide une couche finale d'un alliage de métal précieux ou semi-précieux ayant un aspect et une composition ajustables en fonction de ce que l'on désire obtenir.

Dans ce but, le procédé tel que défini en préambule est caractérisé en ce l'on ajuste la couleur dudit revêtement final en activant silmultanément ou alternativement, pendant de courtes périodes, ledit premier et ledit deuxième dispositif de dépôt, sans apport de gaz réactifs.

Selon une forme de réalisation préférée, un troisième dispositif de dépôt est utilisé pour déposer ledit revêtement superficiel de métal fin comportant au moins un métal d'appoint choisi parmi les métaux suivants : le chrome, l'indium, le platine, le palladium, le rhodium, le ruthénium, l'argent, le zirconium, le titane le hafnium, le niobium, le nickel, le cobalt, le cadmium, le cuivre, l'antimoine, le zinc, l'alluminium ou un alliage de ces métaux.

On peut effectuer le dépôt de la couche de fond au moyen dudit premier dispositif de dépôt, dans un milieu contenant au moins un gaz réactif, de manière à combiner au métal provenant du premier dispositif au moins un des éléments suivants : le carbone, l'oxygène, l'azote, le bore, le silicium, le fluor, le chlore, le soufre, le phosphore ou un mélange de ces éléments.

Les techniques des dépôts sous vide sont bien connues en soi et utilisent soit une évaporation, soit une déposition ionique, soit une pulvérisation cathodique. Les dispositifs de dépôt sous vide sont constitués de une ou plusieurs sources de déposition disposées dans l'enceinte à vide de manière à obtenir des dépôts homogènes sur les objets à revêtir. Ces sources de déposition peuvent être des cathodes dans le cas de la pulvérisation cathodique, ou des évaporateurs à bombardement électronique, à bombardement ionique ou à arcs dans le cas de l'évaporation sous vide ou de la déposition ionique.

La présente invention sera mieux comprise en référence à la description détaillée de plusieurs exemples de réalisation du procédé selon l'invention.

L'enceinte à vide est équipée d'au moins deux dispositifs de dépôt différents. Le premier comporte le matériau destiné à permettre le dépôt d'une couche de céramique qui est composée d'un élément ou d'un alliage d'éléments choisis parmi la liste suivante : le titane, le zirconium, le hafnium, le vanadium, le niobium, le tantale, le chrome, le molybdène, le tungstène et l'aluminium.

Le second dispositif comporte le métal utilisé comme élément principal pour le dépôt final ayant une nuance de couleur désirée, et qui est en général de l'or. Toutefois, il peut s'agir également d'un métal ou d'un alliage des métaux de la liste suivante : l'or, le platine, le palladium, le rhodium, l'argent, l'irridium, l'osmium, le ruthénium ou le rhénium.

Un troisième dispositif, qui n'est pas toujours indispensable, comporte un métal d'apport ou un alliage de métaux choisis parmi la liste suivante : le chrome, l'indium, le platine, le palladium, le rhodium, le ruthénium, l'argent, le zirconium, le titane, le hafnium, le niobium, le nickel, le cobalt, le cadmium, le cuivre, l'argent, l'antimoine, le zinc ou l'aluminium.

Au cours d'une première étape, on décape par bombardement ionique sous vide la surface du substrat de façon à garantir une bonne adhérence. Au cours d'une seconde étape, on dépose sous vide au moins une première couche en utilisant le premier dispositif de dépôt, en ajoutant au métal déposé par introduction d'un gaz réactif dans l'enceinte au moins un des éléments choisis parmi le carbone, l'oxygène, l'azote, le bore, le silicium, le fluor, le chlore, le soufre et le phosphore. Au cours d'une troisième étape, on active la surface de cette première couche par un bombardement ionique sous vide, et on dépose ensuite dans une dernière étape une couche métallique.

Pour ce faire, on utilise simultanément, ou individuellement sous la forme de courtes périodes successives, le second dispositif de dépôt et le premier, ou le premier et le troisième dispositif de dépôt. De cette manière, il est possible de déposer par-dessus la première couche de céramique toute une gamme d'alliages ayant exactement la composition chimique et la nuance de couleur désirées, et ceci sans démonter ni remplacer les sources de dépôt et en ne faisant varier que les paramètres de contrôle de chaque dispositif de dépôt à savoir : vitesse de déposition, durée de déposition et cycle d'utilisation des différents dispositifs.

L'homogénéité de ce revêtement de couverture ainsi que sa couleur peuvent être ajustées par un traitement thermique ultérieur effectué dans l'enceinte de dépôt ou dans un autre équipement.

Selon une forme de réalisation particulièrement intéressante, le procédé consiste, après un décapage ionique du substrat, à déposer sous vide par pulvérisation cathodique, évaporation ou dépôt ionique de titane en présence d'azote, un revêtement de nitrure de titane ayant une composition approximativement stoechiométrique et une épaisseur de 0,1 à 5 µm. Après le dépôt de cette première couche, le procédé consite à préparer sa surface supérieure par décapage ionique sous vide. On procède ensuite au dépôt de la couche finale d'un alliage d'or et de titane en actionnant simultanément les deux dispositifs de dépôt comportant respectivement le titane et l'or. Les quantités d'or et de titane sont ajustées exactement de manière à ce que la couche finale ait exactement la nuance de couleur désirée et une épaisseur finale de 0,1 à 10 µm.

Dans une forme de réalisation un peu différente, les deux dispositifs de dépôt sont actionnées plusieurs fois consécutivement de courts instants de façon à former de fines lamelles successives partiellement transparentes dont l'addition donne un effet final de couleur en surface correspondant exactement à la nuance désirée.

Une autre forme de réalisation plus complexe consiste tout d'abord à effectuer un décapage des substrats par bombardement ionique de leur surface. Dans une seconde phase, au moyen de l'un des procédés de dépôt sous vide décrit précédemment, en utilisant un premier dispositif de dépôt comportant un alliage titane-zirconium et en introduisant dans l'enceinte de l'azote et un hydrocarbure (acétylène par exemple), on réalise une couche céramique de carbonitrure de titane-zirconium ayant une épaisseur comprise entre 0,1 et 5 µm. Après décapage ionique de la surface de cette première couche, on dépose par un procédé sous vide utilisant trois dispositifs de dépôt différents, agissant simultanément ou consécutivement, une couche d'alliage ayant exactement la couleur requise et une épaisseur comprise entre 0,1 et 10 µm.

Le premier dispositif de dépôt, qui est le même que celui utilisé pour la première couche de céramique, comporte un alliage titane-zirconium, le second dispositif comporte de l'or pur, et le troisième dispositif comporte du chrome. Ainsi, en agissant simultanément ou consécutivement sur les trois dispositifs de dépôt, on dépose un alliage or-titane-chrome de composition ajustable dans une large mesure et recouvrant la plupart des nuances de couleurs utilisées et normalisées dans le domaine décoratif. Suivant que les dispositifs sont activés simultanément ou consécutivement, on obtient un revêtement ayant une composition homogène, ou un revêtement constitué de fines lamelles successives partiellement transparentes, de compositions différentes. Dans le premier cas, on peut faire varier la composition de l'alliage en agissant sur la vitesse de dépôt de chaque dispositif, alors que dans le second cas c'est l'épaisseur respective de chaque lamelle et l'ordre dans laquelle elles sont déposées qui permettent d'agir sur la couleur du revêtement final.

Différents objets décoratifs peuvent être traités par ce procédé. A titre d'exemples, une boîte de montre en acier inoxydable, préalablement dégraissée et séchée, a été placée dans une enceinte de dépôt par pulvérisation cathodique équipée de deux dispositifs de dépôt différents. Le premier est une cathode ou un ensemble de cathodes sur lesquelles des cibles de titane pur sont fixées, et le second est une cathode ou un ensemble de cathodes avec des cibles d'or pur. Au cours d'une première étape, la surface de la boîte de montre subit un bombardement ionique avec des ions d'argon, sous une pression réduite, de façon à éliminer les dernières traces superficielles de contaminant. L'objet est ensuite polarisé négativement de quelques dizaines de volts et on commence à déposer du titane et du nitrure de titane à l'aide du premier dispositif de dépôt, en introduisant un flux croissant d'azote et en augmentant progressivement la polarisation du substrat. A la fin du dépôt de nitrure de titane, lorsque le revêtement céramique atteint une épaisseur d'environ 1 µm, la polarisation de l'objet peut s'élever à une valeur comprise entre 150 et 250 V, et la proportion d'atomes d'azote dans le nitrure de titane atteint approximativement 50%. L'opération suivante consiste à bombarder la surface de nitrure de titane avec des ions d'argon dans le but de garantir l'adhérence de la couche suivante. On dépose ensuite par pulvérisation cathodique la couche finale ayant la couleur superficielle désirée en agissant sur les deux dispositifs de dépôt. On enclenche tout d'abord la ou les cathodes d'or de façon à déposer une lamelle de 0,022 µm d'épaisseur, puis on déclenche ce dispositif et on enclenche l'autre dispositif de manière à déposer par-dessus une lamelle de titane pur de 0,002 µm d'épaisseur. Après arrêt du dépôt de titane on redépose une lamelle d'or, puis une nouvelle lamelle de titane et ainsi de suite jusqu'à ce que l'épaisseur totale de la couche titane-or atteigne 0,3 um. On obtient ainsi une couche finale composée de 88% d'or et 12% de titane (% atomiques), et ayant une couleur correspondant à celle de l'alliage normalisé 4N.

Selon un second exemple, on désire déposer à la surface d'un tube de stylo en laiton un revêtement de carbonitrure de titane-zirconium avec une couche superficielle de couleur correspondant exactement à la nuance 1N14. Après nickelage de la surface par un procédé galvanique, l'objet est introduit dans l'installation de dépôt par pulvérisation cathodique qui, dans ce cas, est équipée de trois dispositifs de dépôts différents : le premier avec une ou des cibles titane-zirconium 50%-50% (% atomiques), le deuxième avec une ou des cibles d'or pur et le troisième avec une ou des cibles de chrome. Après un premier décapage ionique de la surface de l'objet, on dépose une première couche de carbonitrure de titane-zirconium en enclenchant le premier dispositif de dépôt et en introduisant dans l'enceinte, en quantité appropriée, de l'azote et de l'acétylène. Le carbonitrure de titane-zirconium a l'avantage, par rapport au nitrure de titane classique, d'avoir une couleur intrinsèque plus proche de celle des alliages d'or avec toutefois une brillance inférieure. Après le bombardement ionique de la surface du revêtement céramique de carbonitrure de titane-zirconium, on applique au moyen des trois dispositifs de dépôt simultanés un alliage composé de titane, de zirconium, d'or et de chrome dans les proportions suivantes : or 93%, titane plus zirconium 3% et chrome 4% (% atomiques). De cette manière, la couche de couverture a une couleur ayant exactement les caractéristiques de couleur d'un alliage 1N14.

Il est clair que ces divers procédés sont applicables non seulement par pulvérisation cathodique, mais également par évaporation sous vide ou par dépôt ionique avec des dispositifs de dépôt constitués d'évaporateurs à effet Joule, à bombardement électronique, à bombardement ionique ou à arc électrique.

Dans certaines réalisations, chaque dispositif de dépôt peut être constitué de plusieurs cathodes, ou de plusieurs évaporateurs, disposés de manière à obtenir un revêtement uniforme sur les objets à revêtir.

## Revendications

1. Procédé de dépôt d'au moins une épaisseur d'au moins un matériau décoratif résistant à l'usure et à la corrosion, sur un substrat constituant au moins une partie d'un objet décoratif, procédé dans lequel on prépare l'objet à traiter en lui faisant subir un décapage ionique, on dépose sur ledit substrat au moins une couche de fond en céramique comportant au moins l'un des éléments suivants : le titane, le zirconium, le hafnium, le vanadium, le niobium, le tantale, le chrome, le molybdène, le tungstène et l'aluminium, ou un alliage de ces éléments, cette couche de fond étant déposée au moyen d'un premier dispositif de dépôt en présence d'un gaz réactif, on active la surface de cette couche de fond par un bombardement ionique sous vide, et on dépose au moins un revêtement superficiel final de métal fin comportant au moins un des éléments suivants : l'or, le platine, le palladium, le rhodium, l'argent, l'irridium, l'osmium, le ruthénium ou le rhénium, ce revêtement superficiel étant déposé par dépôt sous vide au moyen d'un deuxième dispositif de dépôt, le dépôt sous vide étant effectué par l'un des procédés suivants : pulvérisation cathodique, évaporation sous vide ou dépôt ionique, le dépôt de la couche de fond et le revêtement superficiel étant effectués dans une même enceinte à vide au moyen de dispositifs de dépôt sous vide montés dans cette enceinte, caractérisé en ce que l'on ajuste la couleur dudit revêtement final en activant simultanément ou alternativement, pendant de courtes périodes, ledit premier et ledit deuxième dispositif de dépôt, sans apport de gaz réactifs.

2. Procédé selon la revendication I, caractérisé en ce qu'un troisième dispositif de dépôt est utilisé pour déposer ledit revêtement superficiel de métal fin comportant au moins un métal d'appoint choisi parmi les métaux suivants : le chrome, l'indium, le platine, le palladium, le rhodium, le ruthénium, l'argent, le zirconium, le titane le hafnium, le niobium, le nickel, le cobalt, le cadmium, le cuivre, l'antimoine, le zinc, l'alluminium ou un alliage de ces métaux.

3. Procédé selon la revendication 1, caractérisé en ce que l'on effectue le dépôt de la couche de fond au moyen dudit premier dispositif de dépôt, dans un milieu contenant au moins un gaz réactif, de manière à combiner au métal provenant du premier dispositif au moins un des éléments suivants : le carbone, l'oxygène, l'azote, le bore, le silicium, le fluor, le chlore, le soufre, le phosphore ou un mélange de ces éléments.

## Claims

1. A method for depositing at least one wear and corrosion resistant decorative material onto a substrate constituting at least a portion of a decorative object, comprising the steps of preparing the object to be treated by ion stripping the object, depositing at least one base layer of ceramic material onto said object comprising at least one of the following elements: titanium, zirconium, hafnium, vanadium, niobium, tantalum, chromium, molybdenum, tungsten, aluminium, or an alloy of these elements, this base layer being deposited with a first deposition device in presence of a reactive gas, activating the surface of this base layer by vacuum ion bombardment, and depositing at least one final superficial coating of precious metal comprising at least one of the following elements : gold, platinum, palladium, rhodium, silver, iridium, osmium, ruthenium and rhenium, this superficial coating being deposited by vacuum deposition with a second deposition device, said vacuum deposition being realised by one of the following method: cathode pulverisation, vacuum evaporation or ion deposition, the deposition of the base layer and the superficial coating being realised in a single vacuum chamber by means of vacuum deposition devices integrated in the chamber, characterised in that it comprises the step of adjusting the colour of said final coating by simultaneously or alternately activating, for short periods, said first and said second deposition devices, without a supply of reactive gas.

2. A method according to claim 1, characterised in that a third deposition device is used to deposit said superficial coating of precious metal comprising at least a supplementary metal from the group comprising : chromium, indium, platinum, palladium, rhodium, ruthenium, silver, zirconium, titanium, hafnium, niobium, nickel, cobalt, cadmium, copper, antimonium, zinc, aluminium, or an alloy of these metals.

3. A method according to claim 1, characterised in that the deposition of the base layer is realised by means of said first deposition device, in a medium containing at least a reactive gas, in order to combine with the metal from the first device, at least one of the following elements: carbon, oxygen, nitrogen, bore, silicon, fluorine, chlorine, sulphur, phosphorus, or a mixture of these elements.

## Patentansprüche

1. Verfahren für das Abscheiden von mindestens einer Schicht aus mindestens einem dekorativen Werkstoff, der verschleiß- und korrosionsbeständig ist, auf eine Unterlage, die mindestens einen Teil eines dekorativen Gegenstandes bildet, wobei nach diesem Verfahren der zu behandelnde Gegenstand vorbereitet wird, indem er ein ionisches Beizen erfährt, auf die besagte Unterlage mindestens eine Grundschicht aus Keramik aufgebracht wird, die mindestens eines der folgenden Metalle: Titan, Zirkonium, Hafnium, Vanadium, Niobium, Tantal, Chrom, Molybdän, Wolfram und Aluminium oder eine Legierung aus diesen Metallen enthält, wobei diese Grundschicht mit Hilfe einer ersten Vorrichtung unter Zufuhr eines Reagenzgases aufgebracht wird, die Oberfläche dieser Grundschicht durch einen Ionenbeschuß unter Vakuum aktiviert wird und mindestens eine Oberschicht aus Feinmetall, das mindestens eines der folgenden Metalle: Gold, Platin, Palladium, Rhodium, Silber, Iridium, Osmium, Ruthenium oder Rhenium enthält, aufgebracht wird, wobei diese Oberschicht unter Vakuum mit Hilfe einer zweiten Vorrichtung aufgebracht wird, wobei das Abscheiden unter Vakuum nach einem der folgenden Verfahren erfolgt: kathodische Pulverisation, Verdampfung unter Vakuum oder ionische Abscheidung, wobei das Aufbringen der Grundschicht und der Oberschicht in derselben Vakuumkammer mit Hilfe von Vakuumvorrichtungen, die in dieser Kammer eingebaut sind, durchgeführt wird,
**dadurch gekennzeichnet**, daß
die Farbe der Oberschicht eingestellt wird, indem gleichzeitig oder abwechselnd während kürzerer Zeiträume die erste und die zweite Vorrichtung ohne Zufuhr von Reagenzgasen aktiviert werden.

2. Verfahren gemäß Anspruch 1,
**dadurch gekennzeichnet**, daß
eine dritte Vorrichtung für das Abscheiden verwendet wird, um die Oberschicht aus Feinmetall aufzubringen, die mindestens ein Zusatzmetall enthält, das unter den folgenden Metallen gewählt wird: Chrom, Indium, Platin, Palladium, Rhodium, Ruthenium, Silber, Zirkonium, Titan, Hafnium, Niobium, Nickel, Kobalt, Kadmium, Kupfer, Antimon, Zink, Aluminium oder eine Legierung aus diesen Metallen.

3. Verfahren gemäß Anspruch 1,
**dadurch gekennzeichnet**, daß
die Abscheidung der Unterlage mit Hilfe der ersten Vorrichtung unter Zufuhr von mindestens einem Reagenzgas durchgeführt wird, um mit dem Metall, das aus der ersten Vorrichtung kommt, mindestens einen der folgenden Stoffe zu verbinden: Kohlenstoff, Sauerstoff, Stickstoff, Bor, Silizium, Fluor, Chlor, Schwefel, Phosphor oder ein Gemisch aus diesen Stoffen.
